# EUROPÄISCHE PATENTSCHRIFT

(11) **EP 1 643 259 B1**
(45) Veröffentlichungstag und Bekanntmachung des Hinweises auf die Patenterteilung: **10.12.2008**
(21) Anmeldenummer: 05107160.3
(22) Anmeldetag: 03.08.2005
(51) Int. Cl.: G01R 31/34

(54) **Verfahren und Vorrichtung zur Detektion von Streifstellen an rotierenden Maschinen**
Method and device for detecting touching points on rotating machines
Procédé et dispositif pour la détection des points de contact dans des machines tournantes

(30) Priorität: 12.08.2004 CH 13322004
(43) Veröffentlichungstag der Anmeldung: 05.04.2006
(73) Patentinhaber: Alstom Technology Ltd, 5400 Baden (CH)
(72) Erfinder: Hobelsberger, Max, 5303, Würenlingen (CH)

(56) Entgegenhaltungen:
- WO-A-20/04025316
- WO-A-20/04025811
- DE-B- 1 217 493
- US-A- 3 831 160
- US-B1- 6 460 013

## Beschreibung

### TECHNISCHES GEBIET

Die vorliegende Erfindung betrifft ein Verfahren und eine Vorrichtung zur Überwachung von rotierenden Maschinen nach dem Oberbegriff des unabhängigen Anspruchs 1, sowie eine Vorrichtung zur Überwachung von rotierenden Maschinen nach dem Oberbegriff des unabhängigen Anspruchs 10. Das Verfahren ist zur Detektion von Streif- oder Kontaktstellen an Maschinen mit sich drehenden Wellen wie beispielsweise Generatoren, Turbinen, Motoren, im Betrieb geeignet. Das Verfahren ist geeignet Wellenreiben, d.h. das Auftreten von Streifstellen oder Kontaktstellen der Antriebswelle mit dem Gehäuse zu erkennen. Ein spezieller Einsatzzweck ist die Überwachung der Lagerisolation bei Generatoren.

### STAND DER TECHNIK

Elektrische Maschinen, insbesondere grosse elektrische Maschinen, wie sie bei Kraftwerksanlagen verwendet werden, sollten, um einen reibungslosen Betrieb zu gewährleisten, kontinuierlich überwacht werden und/oder von Zeit zu Zeit analysiert werden, um Fehlerzustände rechtzeitig zu erkennen und unkontrollierte Ausfälle zu vermeiden.

Die EP 0 271 678 A1 schlägt z.B. eine Vorrichtung vor, mit welcher Aussagen über die Funktionstüchtigkeit und Funktionssicherheit der Wellenerdung respektive der Isolation der Welle gemacht werden können. Die dabei vorgeschlagene Vorrichtung, welche eigentlich zur Reduktion von Wellenspannungen vorgesehen ist, lässt Aussagen über die gesamten Erdungsverhältnisse der elektrischen Maschine zu.

Wenn die drehende metallische Welle einer Maschine die sie umgebenden Gehäuseteile metallisch berührt oder streift, tritt Abnützung auf. Bei Generatoren können zudem erhebliche elektrische Ströme über die Kontaktstellen fliessen, die zu Erhitzungen, Erosion und sogar Schmelzprozessen führen. Es ist entsprechend erstrebenswert, diese metallischen Berührungen im Betrieb zu detektieren und die Streifstellen zu lokalisieren.

Stand der Technik ist es z.B. zur Detektion von Streifstellen die Lager von Maschinen doppelt zu isolieren und zwischen den beiden Isolationsschichten eine leitende Schicht anzuordnen. Es wird nun überwacht, ob diese leitende Zwischenschicht eine ohmsche leitende Verbindung zur Welle oder nach Erde aufweist. Falls dies zutrifft, ist eine der Isolationsschichten defekt. Nachteilig bei diesem Verfahren ist, dass nur selektiv die Isolationsschichten im Lager überprüft werden, nicht jedoch die Wellenisolation an sich, d.h. der Isolationszustand der gesamten Welle kann nicht bestimmt werden. Es kann somit z.B. nicht festgestellt werden, ob die Welle das Gehäuse direkt berührt. Nachteilig bei diesem Verfahren ist u.a., dass nur die Isolationsschichten im Lager überprüft werden, nicht jedoch die Wellenisolation an sich. Es kann nicht festgestellt werden, ob die Welle z.B. das Gehäuse berührt. Weiterhin existieren Verfahren, bei welchen Ströme durch die Welle mittels

Rogowsky-Spulen gemessen werden. Auch hier werden nicht direkt Kontaktstellen der Welle mit dem Gehäuse oder Erde detektiert, sondern nur die indirekten Folgen dieser Kontakte.

Die EP 0 503 846 A2 beschreibt ein Verfahren sowie eine Vorrichtung zur Detektion von Fehlstellen in der Isolation zwischen einer Welle eines Generators und den Lagern respektive Dichtungen, welche diese führen. Zur Messung wird ein Transformator um die stillstehende Welle gelegt und dieser mit Wechselstrom angesteuert. Anschliessend wird über ein Spannungsmessgerät, welches einerseits auf Erde ist und andererseits mit der Welle an einer Stelle verbunden wird, bei welcher eine Fehlstelle vermutet wird, die Spannung gemessen. Derartige Verfahren erlauben zwar ein gutes Ausmessen von Fehlstellen im Stillstand, aber die ausschliesslich bei Betrieb auftretenden Streif- oder Kontaktstellen können so nicht gefunden werden.

WO-A-2004/025316, WO-A-2004/025811, DE-B-1217493, US-A-3831160 sowie US-B-6460013 beschreiben Verfahren zum Erkennen von Streif- und/oder Kontaktstellen an Maschinen mit drehenden Wellen. Bei diesen Verfahren werden Streif- oder Kontaktstellen einer Welle ermittelt, indem alle Ströme gemessen werden, welche über vorgesehene Erdverbindungen der Welle nach Erde fliessen.

### DARSTELLUNG DER ERFINDUNG

Der Erfindung liegt demnach die Aufgabe zugrunde, ein verbessertes Verfahren zur Detektion von Streif- oder Kontaktstellen an Maschinen mit sich drehenden Wellen zur Verfügung zu stellen, sowie eine Vorrichtung zur Durchführung eines derartigen Verfahrens. Es handelt sich dabei insbesondere um ein Verfahren, bei welchem Streif- oder Kontaktstellen der rotierenden Welle, d. h. während des Betriebs der Maschine bestimmt werden können. Erfindungsgemäss weist das Verfahren die Merkmale des kennzeichnenden Teils des unabhängigen Andpruchs 1 auf. Die erfindungsgemässe Vorrichtung weist die Merkmale im kennzeichnenden Teil des unabhängigen Anspruchs 10 auf.

Der Kern der Erfindung besteht somit darin, unter Verwendung eines Prüfstroms über die an den Erdungsvorrichtungen auftretenden Ströme, zur Erde Rückschlüsse über den Isolationszustand der Welle zu ziehen.

Gemäss der Erfindung wird der Erdungszustand der Welle über wenigstens ein mit der Welle elektrisch verbundenes Erdungsmodul ermittelt, indem die Spannung zur Erde über einem Erdungswiderstand gemessen wird.

Die abhängigen Ansprüche beziehen sich auf vorteilhafte Ausführungsformen der Erfindung.

Vorzugsweise wird dabei zur Vereinfachung der Analyse so vorgegangen, dass Ströme, die von der Welle nach Erde fliessen, als positiv gewertet werden.

Zur Detektion des Isolationsverhaltens wird wenigstens zeitweise, d. h. beispielsweise intermittierend, ein quantitativ bestimmter Prüfstrom auf die Welle injiziert wird. Die Injektion eines Prüfstroms auf die Welle erlaubt es insbesondere, das Isolationsverhalten quantitativ auszuwerten, da im wesentlichen überprüft werden kann, welcher Anteil des Prüfstroms über die Erdungsvorrichtungen abfliesst (dieser Anteil wird gemessen) und welcher Anteil entsprechend über ungewollte Kontakte abfliesst. Beim Prüfstrom handelt es sich vorzugsweise um einen Strom mit bekanntem Gleichanteil im Bereich von 10 bis 100 mA, insbesondere mit Gleichanteil im Bereich von 20 bis 40 mA.

Bevorzugt wird dabei der Prüfstrom über eine Erdverbindung, insbesondere über eine mit der Welle Kontakt bildende Erdungsbürste oder einen entsprechenden Schleifkontakt, auf die Welle, injiziert. Es ist möglich, für die Injektion des Prüfstroms eine separate Kontaktvorrichtung vorzusehen, die bereits über die Erdungsbürste zur Verfügung stehende Kontaktmöglichkeit vereinfacht das Verfahren aber wesentlich.

Das vorliegende Verfahren findet z.B. bei Generatoren Anwendung. Normalerweise sind bei Generatoren Erdungsvorrichtungen bereits vorhanden, diese sogenannten Erdungsmodule sind dabei typischerweise sowohl auf der Turbinenseite als auch auf der anderen Seite des Generators angeordnet. Besonders einfach lässt sich das Verfahren ausführen, wenn gemäss einer weiteren bevorzugten Ausführungsform der Prüfstrom wenigstens mittelbar über eines oder aber auch zwei dieser Erdungsmodule auf die Welle gebracht wird. Dabei kann der Prüfstrom entweder in das Erdungsmodul eingekoppelt werden, es ist aber auch möglich, den Prüfstrom über die mit dem Erdungsmodul verbundene Erdungsbürste zu injizieren. Bei den vorgesehenen Erdverbindungen kann es sich um wenigstens ein Erdungsmodul handeln, welches über wenigstens eine Erdungsbürste mit der Welle sowie mit der Erde in Kontakt steht.

Eine quantitative Auswertung insbesondere bei einer intermittierenden Injektion von Prüfstrom lässt sich gemäss einer anderen Ausführungsform erreichen, indem die Detektion von Streif- oder Kontaktstellen über einen Vergleich der Grösse des Prüfstroms mit der Differenz der über vorgesehene Erdverbindungen der Welle nach Erde fliessenden Ströme ohne anliegenden Prüfstrom (Gesamterdungsstrom ohne Prüfstrom) mit dem über vorgesehene Erdverbindungen der Welle nach Erde fliessenden Ströme mit anliegendem Prüfstrom (Gesamterdungsstrom mit Prüfstrom) erfolgt. Auf diese Weise kann direkt die Leitfähigkeit der Streif- oder Kontaktstellen aus dem Vergleich der Grösse des Prüfstroms mit der Differenz ermittelt werden.

Gemäss einer anderen bevorzugten Ausführungsform wird, um typischerweise auf der Welle vorhandene Wechselstromanteile auszumitteln, von den Strömen, welche über vorgesehene Erdverbindungen der Welle nach Erde fliessen, nur der Gleichstromanteil ausgewertet. Eine weitere Verbesserung der Auswertung lässt sich erreichen, indem die Ströme, welche über vorgesehene Erdverbindungen der Welle nach Erde fliessen, zeitlich gemittelt und/oder gefiltert werden. Bei einer Rotation der Welle im Bereich von 50 bis 60 Hz erweist sich eine Mittelung über 5 sec, vorzugsweise über 10 sec als genügend.

Des weiteren betrifft die vorliegende Erfindung eine Vorrichtung zur Durchführung eines Verfahrens, wie es oben beschrieben ist. Die Vorrichtung ist insbesondere dadurch gekennzeichnet, dass wenigstens ein Erdungsmodul über wenigstens eine mit der Welle Kontakte bildende Erdungsbürste (oder eine andere Kontaktstellen, zum Beispiel Schleifkontakt) vorgesehen ist, wobei das wenigstens eine Erdungsmodul über wenigstens einen Erdungswiderstand verfügt. Weiterhin ist eine Einheit angeordnet, welche wenigstens mittelbar über das Erdungsmodul einen Kontakt für die Injektion eines definierten Prüfstroms auf die Welle aufweist, und welche die über dem wenigstens einen Erdungswiderstand anliegende Spannung abgreift respektive misst oder die entsprechenden Messwerte von dem Erdungsmodul übermittelt bekommt.

Gemäss einer bevorzugten Ausführungsform verfügt die Einheit über Mittel zur Messung und/oder Auswertung der Streif- oder Kontaktstellen auf Basis des quantitativen Werts des Prüfstroms und der über die Erdungswiderstände abfliessenden Erdungsströme. Optional ist diese als Mess- und Auswertungsmodul ausgebildete Einheit Bestandteil wenigstens eines der Erdungsmodule.

Weitere bevorzugte Ausführungsformen des Verfahrens respektive der Vorrichtung sind in den abhängigen Patentansprüchen beschrieben.

### KURZE ERLÄUTERUNG DER FIGUREN

Die Erfindung soll nachfolgend anhand von Ausführungsbeispielen im Zusammenhang mit den Zeichnungen näher erläutert werden. Es zeigen:
- Fig. 1: eine schematische Darstellung einer rotierenden Maschine mit Erdungs- und Messvorrichtungen; und
- Fig. 2: eine schematische Darstellung der elektrischen Konnektivität einer rotierenden Maschine mit Erdungs- und Messvorrichtungen gem. Figur 1.

### WEGE ZUR AUSFÜHRUNG DER ERFINDUNG

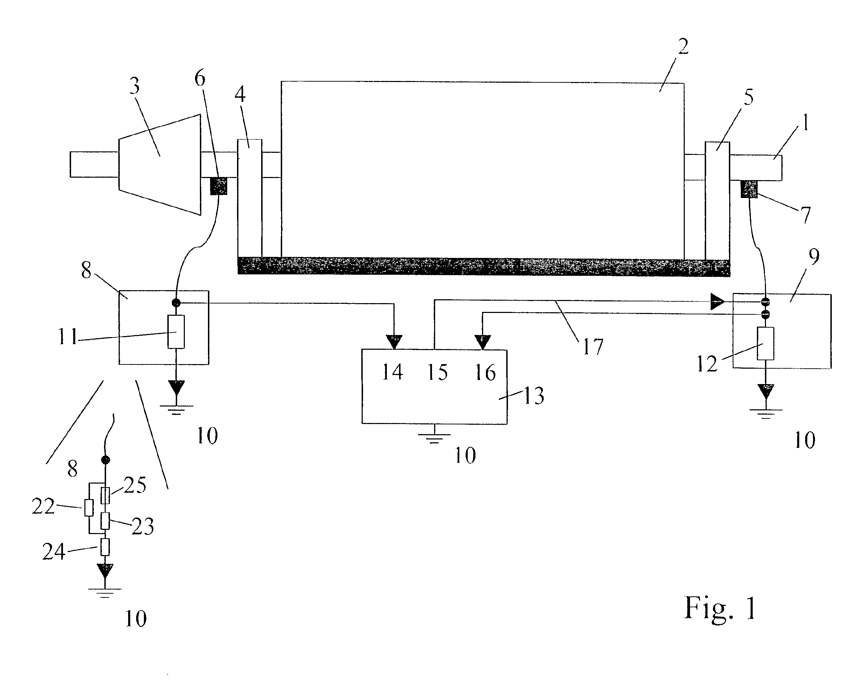

Fig. 1 zeigt einen schematischen Aufbau, bei welchem auf einer Welle 1 eine Turbine 3 angeordnet ist sowie ein Generator 2. Die Welle ist über zwei Lager 4 und 5 gelagert. Weitere Lagerstellen beispielsweise hinter der Turbine sind nicht dargestellt. Die Welle eines Generators 2 wird normalerweise geerdet, dies geschieht über so genannte Erdungsmodule. Im konkreten Fall sind zwei derartige Erdungsmodule 8 und 9 vorhanden.

Ein erstes Erdungsmodul 8 ist turbinenseitig angeordnet und über eine Erdungsbürste 6 mit der Welle 1 kontaktiert. Erdungsmodul 8 und Erdungsbürste 6 bilden eine erste Erdverbindung.

Ein zweites Erdungsmodul 9 ist auf der anderen Seite des Generators angeordnet und verfügt seinerseits über eine Erdungsbürste 7, über welche das Erdungsmodul 9 mit der Welle 1 in elektrischer Verbindung steht. Erdungsmodul 9 und Erdungsbürste 7 bilden eine zweite Erdverbindung.

Beide Erdungsmodule 8 und 9 sind mit der Erde 10 verbunden. Anstelle der Erdungsbürsten 6,7 können auch Schleifkontakte oder andere Mittel zu Kontaktierung der Welle verwendet werden.

Obwohl dies für die vorliegende Erfindung nicht erforderlich ist, können die Erdungsmodule 8 und 9 dabei durchaus komplexere Bauteile sein. So kann es sich beispielsweise bei dem auf der Antriebseite angeordneten Erdungsmodul 8 um ein so genanntes DE-Modul handeln, wie es unter anderem in der WO 2004/025316 A1 beschrieben ist. Ein derartiges DE-Modul (vgl. Inlay in Fig. 1) verfügt über einen hochohmigen Widerstand 22 (R_{DE,1}, 10Ω) zur Kontaktvorrichtung, hier zur Erdungsbürste 6, an die Welle und über einem niederohmigen Widerstand 23 (R_{DE,2}, 1Ω), welcher z.B. als Erdungswiderstand 11 verwendet werden kann, zur Erde 10, wobei parallel zum hochohmigen Widerstand 22 eine Sicherung 25 angeordnet ist, und wobei zum Beispiel zwischen Erde und niederohmigem Widerstand 23 ein Messwiderstand 24 (0.1Ω) angeordnet ist. Es kann dann zu Diagnosezwecken die Wellenspannung zwischen hochohmigem Widerstand und Kontaktvorrichtung und Erdanschluss, und der Wellenstrom über dem Messwiderstand abgegriffen werden.

Beim zweiten Erdungsmodul 9 kann es sich um eine Einheit handeln, wie sie in der bereits genannten EP 271 678 A1 beschrieben ist.

Wesentlich ist im Zusammenhang mit den beiden Erdungsmodulen 8 und 9 aber, dass sie jeweils über einen Erdungswiderstand 11 respektive 12 verfügen, welcher es erlaubt, die über diesem im ohmschen Wert bekannten Widerstand 11 respektive 12 gemessene Spannung den zur Erde 10 abfliessenden Strom zu ermitteln.

Im vorliegenden Fall ist nun eine zusätzliche, als Mess- und Auswertungsmodul ausgebildete Einheit 13 vorhanden. Dieses Mess- und Auswertungsmodul 13 greift einerseits die über den Widerständen 11 und 12 auftretenden Spannungen ab und misst diese, wie dies mit den Bezugszeichen 14 und 16 angedeutet ist.

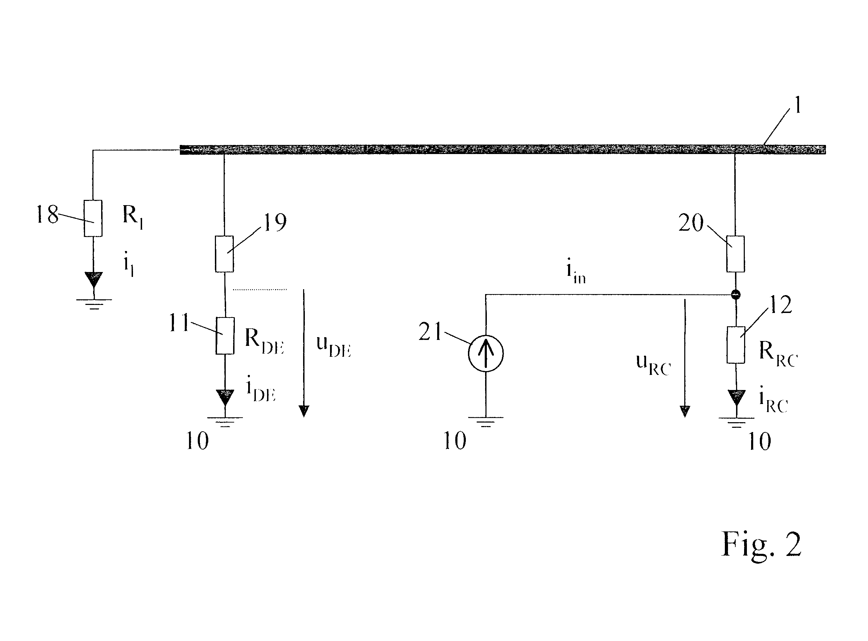

Ausserdem verfügt das Mess- und Auswertungsmodul 13 über eine Stromquelle 21 (Fig. 2), welche einen wohl definierten bzw. bekannten Prüfstrom, welcher auf die Welle 1 injiziert wird, und die quantitative Durchführung des Verfahrens ermöglicht. Ein typischer DC-Prüfstrom hat eine Stärke von 20 bis 40 mA, z.B. von ca. 30 mA. Das Mess- und Auswertungsmodul 13 kann zusätzlich über Hard- und Software verfügen, welche eine weitergehende Analyse ermöglicht. Weiterhin kann das Mess- und Auswertungsmodul 13 Bestandteil eines der beiden Erdungsmodule 8 oder 9 sein. Auch das Mess- und Auswertungsmodul 13 verfügt über eine Verbindung zur Erde 10.

Um das Verfahren genauer beschreiben zu können, zeigt Fig. 2 die elektrische Konnektivität einer Anordnung gem. Fig. 1. Ein Reibstellen-Kontakt ist dabei schematisch durch einen Reibstellenwiderstand 18 mit dem ohmschen Wert R_{I} dargestellt. Über diese Fehlstelle der Isolation fliesst ein Strom i_{I} zur Erde 10. Weiterhin ist dargestellt, wie über das erste Erdungsmodul 8 ein Strom i_{DE} zur Erde 10 abfliesst. Dieser Strom i_{DE} kann über die über dem ersten Erdungswiderstand 11 mit dem Wert R_{DE} (z.B. ein Gleichstromwiderstand mit dem Wert 1 Ohm) messbare Spannung ermittelt werden. Das erste Erdungsmodul 8 verfügt über einen Bürstenkontaktwiderstand 19 zur Welle 1.

Im zweiten Erdungsmodul 9 ist der zweite Erdungswiderstand 12 mit dem Wert R_{RC} angeordnet (z.B. ein Gleichstromwiderstand mit dem Wert 470 Ohm), und es fliesst ein Strom i_{RC} zur Erde 10. Dieser Strom kann infolge des bekannten Werts von R_{RC} durch die über dem Widerstand 12 anliegende Spannung u_{RC} ermittelt werden.

Es muss betont werden, dass das vorliegende Verfahren auch mit nur einer Erdungsstelle 8 oder 9 funktioniert.

Das neuartige Verfahren zeichnet sich nun u.a. dadurch aus, dass ein elektrischer Prüfstrom iᵢₙ bekannter Grösse in die Welle 1 injiziert wird, und, simultan dazu, alle über die normalen und gewollten Kontakte (Erdungsbürsten 6 und 7 respektive Erdungsmodule 8 und 9) abfliessenden Ströme, d.h. i_{DE} und i_{RC}, gemessen werden.

Eine Summenbildung über alle Stromgrössen muss im Falle idealer Wellenisolation den Wert 0 ergeben, d.h. die Summe der gemessenen zufliessenden Ströme entspricht der Summe der gemessenen abfliessenden Ströme. Im Falle von Streifstellen ist diese Bilanz gestört, die Summe der zufliessenden Ströme ist ungleich der Summe der gemessenen abfliessenden Ströme.

Zur Durchführung des Verfahrens werden nun folgende Massnahmen ergriffen:
- In alle gewollten Erdungsverbindungen, d. h. die beiden Erdungsmodule 8 und 9, werden ohmsche Widerstände, d.h. die Erdungswiderstände 11 respektive 12, bekannter Grösse eingefügt, um definierte elektrische Verhältnisse zu schaffen. Dies dient zur Abschätzung der "Stärke" der Streifstelle, d.h. des zeitlich mittleren Widerstandes R_{I} der Streifstelle.
- Alle über diese gewollten Erdungskontakte nach Erde fliessenden Ströme, d.h. i_{DE} sowie i_{RC}, werden gemessen.
- Vorteilhafterweise werden dabei nur die Gleichanteile (DC) der Ströme gemessen. Dies deshalb, da die Grösse zusätzlich zufliessender oder abfliessender Wechselströme (kapazitive Verschiebungsströme) zeitlich wechselnd, weitgehend unbekannt und normalerweise schwer messbar ist. Der Gleichanteil zusätzlich zufliessender Ströme ist zwar unbekannt, jedoch kurz- und mittelfristig konstant, und er entspricht primär der in der Turbine erzeugten statischen Elektrizitätsmenge. Die Gleichanteile werden durch zeitliche Mittelung über grössere Zeitperioden, beispielsweise über Zeitabschnitte im Bereich von 1 bis 10 sec, bzw. Filterung der Signale ermittelt. Dies beseitigt gleichzeitig auch sehr gut die Messungenauigkeiten aufgrund von Messrauschen.
- Eine sehr vorteilhafte Massnahme ist die zeitlich differentielle Messung: Es werden in zeitlich naher Abfolge die Summe S₀ der nach Erde abfliessenden Ströme i_{DE} und i_{RC} ohne zusätzlichen injizierten Strom iᵢₙ gemessen und kurz danach, oder auch kurz davor, die Summe S₁ der abfliessenden Ströme mit zusätzlichem injizierten Strom iᵢₙ. Die Differenz aus beiden Stromsummen S₁ - S₀ wird dann mit der Grösse des injizierten Stromes iᵢₙ verglichen. Bei idealer Isolation und Messqualität sind beide Werte gleich. Dieses Vorgehen dient dazu, unbekannte, aber zeitlich konstante Ströme (wie z.B. den durch statische Aufladung der Turbine verursachten Strom) aus der Bilanz zu eliminieren.

Somit lassen sich folgende Aussagen auf Basis der gemessenen Ströme machen:
- wenn gilt: iᵢₙ = i_{DE} + i_{RC}, so liegt ideale Wellenisolation vor, d.h. keine Reibstellen (R_{I} unendlich gross).
- Wenn gilt: iᵢₙ = i_{RC}, so muss die Sicherung im zweiten Erdungsmodul 9 durchgebrannt sein, denn der gesamte injizierte Strom fliesst nur über das zweite Erdungsmodul 9 zur Erde 10.
- wenn gilt: u_{RC}>> u_{DE} oder mit anderen Worten i_{RC} >> i_{DE} · (R_{DE}/ R_{RC}), so müssen die Bürstenkontakte an den Erdungsbürsten 6, 7 schlecht sein.
- wenn gilt u_{DE}/i_{DE} = R_{DE,1}, d.h. im konkreten Fall u_{DE}/i_{DE} = 10 Ω, so muss die Sicherung im ersten Erdungsmodul defekt sein.

Zusammenfassend lässt sich festhalten, dass sich das vorliegend beschriebene Verfahren respektive die Vorrichtung zur Durchführung dieses Verfahrens bevorzugt durch folgende Merkmale auszeichnet:
- die Maschinen-Welle 1 ist über eine oder mehrere Erdungsbürsten 6, 7 elektrisch mit der Erde 10 verbunden, wobei in alle diese Erdverbindungen ohmsche Widerstände, d.h. Erdungswiderstände 11, 12 bekannter Grösse eingefügt sind.
- ein Mess- und Auswertungsmodul 13 misst alle Ströme i_{DE} und i_{RC}, die über die Erdungsmodule 8, 9 nach Erde 10 fliessen.
- das Mess- und Auswertungsmodul 13 summiert diese Ströme vorzeichenrichtig, d.h. Ströme, die von der Welle 1 nach Erde 10 fliessen, werden z.B. als positiv gewertet, und somit den Erdungs-Gesamtstrom S₀ (i_{DE} + i_{RC}) ermittelt, der über diese Erdverbindungen nach Erde 10 fliesst.
- das Mess- und Auswertungsmodul 13, das auch mit der Erde 10 verbunden ist, injiziert zeitlich intermittierend einen zusätzlichen Prüfstrom iᵢₙ bekannter Grösse auf die Welle 1, wobei die positive Richtung vom Mess- und Auswertungsmodul 13 nach der Welle 1 weist, und zugleich wiederum die Summe der nach Erde abfliessenden Ströme S₁ ermittelt wird.
- das Mess- und Auswertungsmodul 13 vergleicht die Grösse des Gesamterdungsstromes S_{0,0} ohne Injektion von Prüfstrom mit der Grösse des Gesamterdungsstromes S_{0,1} mit Injektion von Prüfstrom. Die Differenz der beiden Grössen, d.h. Gesamterdungsstrom mit Injektion von Prüfstrom 17 minus Gesamterdungsstrom ohne Injektion von Prüfstrom 17, wird anschliessend mit der Grösse des injizierten Stromes iᵢₙ verglichen. Falls diese Erdungsstromdifferenz von der Grösse des injizierten Stromes abweicht, wird dies als Hinweis auf Wellenstreifen und Wellenreiben gewertet.
- Aus der Grösse der Abweichung, welche dem über die Streifstelle abfliessenden Strom i_{I} entsprechen muss, wird anschliessend die Leitfähigkeit (respektive der Widerstand R_{I}) der Streifstelle abgeschätzt, dies gemäss den Prinzipien der Stromaufteilung über Widerstände.

### BEZUGSZEICHENLISTE

- 1: Welle
- 2: Generator
- 3: Turbine
- 4: erstes Lager
- 5: zweites Lager
- 6: erste Erdungsbürste
- 7: zweite Erdungsbürste
- 8: erstes Erdungsmodul
- 9: zweites Erdungsmodul
- 10: Erde
- 11: erster Erdungswiderstand
- 12: zweiter Erdungswiderstand
- 13: Einheit, Mess- und Auswertungsmodul
- 14: Messung Erdungsstrom über 11
- 15: Messung injizierter Strom
- 16: Messung Erdungsstrom über 12
- 17: injizierter Strom, Prüfstrom
- 18: Reibstellenwiderstand
- 19: Bürstenkontaktwiderstand von 8
- 20: Bürstenkontaktwiderstand von 9
- 21: Stromquelle
- 22: hochohmiger Widerstand, R_{DE,1}
- 23: niederohmiger Widerstand, R_{DE,2}
- 24: Messwiderstand
- 25: Sicherung

- R_{DE}: Widerstandswert von 11
- R_{RC}: Widerstandswert von 12
- R_{I}: Widerstandswert von 18
- i_{DE}: Erdungsstrom über 8
- i_{RC}: Erdungsstrom über 9
- i_{I}: Erdungsstrom über Reibstelle
- iᵢₙ: Wert des Prüfstroms
- u_{DE}: Spannung über 11
- u_{RC}: Spannung über 12
- S₀: Gesamterdungsstrom ohne Prüfstrom
- S₁: Gesamterdungsstrom mit Prüfstrom

## Patentansprüche

1. Verfahren zur Detektion von Streif- oder Kontaktstellen an Maschinen mit sich drehenden Wellen, bei welchem Verfahren Streif- oder Kontaktstellen einer Welle (1) beim Betrieb über eine Messung des Erdungszustands der Welle (1) ermittelt werden, indem alle Ströme (i_{DE}, i_{RC}) gemessen werden, welche über vorgesehene Erdverbindungen (6, 7, 8, 9) der Welle (1) nach Erde (10) fliessen **dadurch gekennzeichnet dass**
wenigstens zeitweise ein Prüfstrom (17) auf die Welle (1) injiziert wird; dass die Detektion von Streif- oder Kontaktstellen über einen Vergleich der Grösse des Prüfstroms (17) mit der Differenz (S₁-S₀) des über vorgesehene Erdverbindungen (6, 7, 8, 9) der Welle (1) nach Erde (10) fliessenden Gesamterdungsstromes (S₁) mit anliegendem Prüfstrom (17) mit dem über vorgesehene Erdverbindungen (6, 7, 8, 9) der Welle (1) nach Erde (10) fliessenden Gesamterdungsstrom (S₀) ohne anliegenden Prüfstrom (17) erfolgt,
und dass eine Abweichung der Erdungsstromdifferenz von der Grösse des injizierten Prüfstroms (17) als Hinweis auf Wellenstreifen und/oder Wellenreiben gewertet wird.

2. Verfahren nach Anspruch 1, **dadurch gekennzeichnet, dass** der Erdungszustand der Welle (1) über wenigstens ein mit der Welle (1) elektrisch verbundenes Erdungsmodul (8, 9) ermittelt wird, indem die Spannung (u_{RC}, u_{DE}) zur Erde (10) über einem Erdungswiderstand (11, 12) gemessen wird.

3. Verfahren nach Anspruch 1 oder 2, **dadurch gekennzeichnet, dass** Ströme (i_{RC}, i_{DE}), die von der Welle (1) nach Erde (10) fliessen, als positiv gewertet werden.

4. Verfahren nach Anspruch 1, 2 oder 3, **dadurch gekennzeichnet, dass** der Prüfstrom (17) über eine Erdverbindung (6, 7), insbesondere über eine mit der Welle (1) Kontakte bildende Erdungsbürste (6, 7) oder einen entsprechenden Schleifkontakt auf die Welle (1) injiziert wird.

5. Verfahren nach einem der Ansprüche 1 bis 4, **dadurch gekennzeichnet, dass** der Prüfstrom (17) wenigstens mittelbar über ein Erdungsmodul (8, 9) auf die Welle gebracht wird.

6. Verfahren nach einem der Ansprüche 1 bis 5, **dadurch gekennzeichnet, dass** die Leitfähigkeit der Streif- oder Kontaktstellen aus dem Vergleich der Grösse des Prüfstroms (17) mit der Differenz aus dem Gesamterdungsstrom (S₁) mit anliegendem Prüfstrom (17) und dem Gesamterdungsstrom (S₀) ohne anliegenden Prüfstrom (17) gemäss den Prinzipien der Stromaufteilung über Widerstände ermittelt wird.

7. Verfahren nach einem der vorhergehenden Ansprüche, **dadurch gekennzeichnet, dass** von den Gesamterdungsströmen (S₀, S₁), welche über vorgesehene Erdverbindungen (6, 7, 8, 9) der Welle (1) nach Erde (10) fliessen, nur der Gleichstromanteil ausgewertet wird.

8. Verfahren nach Anspruch 7, **dadurch gekennzeichnet, dass** die Gesamterdungsströme (S₀, S₁), welche über vorgesehene Erdverbindungen (6, 7, 8, 9) der Welle (1) nach Erde (10) fliessen, zeitlich gemittelt und/oder gefiltert werden.

9. Verfahren nach einem der vorhergehenden Ansprüche, dass es sich bei den vorgesehenen Erdverbindungen um wenigstens ein Erdungsmodul (8, 9) handelt, welches über wenigstens eine Erdungsbürste (6, 7) mit der Welle (1) sowie mit der Erde (10) in Kontakt steht.

10. Vorrichtung zur Durchführung des Verfahrens nach einem der vorhergehenden Ansprüche, mit wenigstens einem Erdungsmodul (8, 9) mit einer mit der Welle (1) Kontakte bildenden Erdungsbürste (6, 7), wobei das wenigstens eine Erdungsmodul (8, 9) über wenigstens einen Erdungswiderstand (11, 12) verfügt,
**dadurch gekennzeichnet, dass** eine Einheit (13) angeordnet ist, welche wenigstens mittelbar über das Erdungsmodul (8, 9) einen Kontakt für die Injektion eines definierten Prüfstroms (17) auf die Welle (1) aufweist, und welche die über dem wenigstens einen Erdungswiderstand (11, 12) anliegende Spannung (u_{DE}, u_{RC}) abgreift,
und dass die Einheit (13) über Mittel zur Messung und/oder Auswertung der Streif- oder Kontaktstellen auf Basis der Grösse des Prüfstroms (17) und der über die Erdungswiderstände (11, 12) abfliessenden Erdungsströme (i_{DE}, i_{RC}) verfügt, wobei die Einheit (13) vorzugsweise als Bestandteil wenigstens eines der Erdungsmodule (8, 9) ausgebildet ist.

## Claims

1. Method for detecting touching points or contact points on machines having rotating shafts, in which method touching points or contact points on a shaft (1) are determined during operation by measuring the grounding state of the shaft (1) by all of the currents (i_{DE}, i_{RC}) being measured which flow to ground (10) via predetermined ground connections (6, 7, 8, 9) of the shaft (1) **characterized in that** a test current (17) is injected at least at times into the shaft (1); **in that** the detection of touching points or contact points takes place by means of a comparison of the value of the test current (17) with the difference (S₁-S₀) between the total ground current (S₁) flowing to ground (10) via ground connections (6, 7, 8, 9) provided on the shaft (1) with the test current (17) being applied and the total ground current (S₀) flowing to ground (10) via ground connections (6, 7, 8, 9) provided on the shaft (1) without the test current (17) being applied, and **in that** a discrepancy between the ground current difference and the value of the injected test current (17) is considered to be an indication of shaft touching and/or shaft friction.

2. Method according to Claim 1, **characterized in that** the grounding state of the shaft (1) is determined by means of at least one grounding module (8, 9) which is electrically connected to the shaft (1), by the voltage (u_{RC}, u_{DE}) to ground (10) being measured via a grounding resistor (11, 12).

3. Method according to Claim 1 or 2, **characterized in that** currents (i_{RC}, i_{DE}) which flow from the shaft (1) to ground (10) are evaluated as being positive.

4. Method according to one of Claims 1, 2 or 3, **characterized in that** the test current (17) is injected into the shaft (1) via a ground connection (6, 7), in particular via a grounding brush (6, 7) forming contacts with the shaft (1) or a corresponding sliding contact.

5. Method according to one of Claims 1 to 4, **characterized in that** the test current (17) is applied to the shaft at least indirectly via a grounding module (8, 9).

6. Method according to one of Claims 1 to 5, **characterized in that** the conductivity of the touching points or contact points is determined from the comparison of the value of the test current (17) with the difference between the total ground current (S₁) with the test current (17) being applied and the total ground current (S₀) without the test current (17) being applied in accordance with the principles of current splitting via resistors.

7. Method according to one of the preceding claims, **characterized in that,** of the total ground currents (S₀, S₁) which flow to ground (10) via ground connections (6, 7, 8, 9) provided on the shaft (1), only the DC component is evaluated.

8. Method according to Claim 7, **characterized in that** the total ground currents (S₀, S₁) which flow to ground (10) via ground connections (6, 7, 8, 9) provided on the shaft (1) are averaged over time and/or filtered.

9. Method according to one of the preceding claims, **characterized in that** the ground connections provided are at least one grounding module (8, 9) which is in contact with the shaft (1) and with ground (10) via at least one grounding brush (6, 7).

10. Device for carrying out the method according to one of the preceding claims, with at least one grounding module (8, 9) with a grounding brush (6, 7) forming contacts with the shaft (1), the at least one grounding module (8, 9) having at least one grounding resistor (11, 12), **characterized in that** a unit (13) is arranged which has, at least indirectly via the grounding module (8, 9), a contact for injecting a defined test current (17) into the shaft (1) and taps off the voltage (u_{DE}, u_{RC}) applied across the at least one grounding resistor (11, 12), and **in that** the unit (13) has means for measuring and/or evaluating the touching points or contact points on the basis of the value of the test current (17) and of the ground currents (i_{DE}, i_{RC}) flowing out via the grounding resistors (11, 12), the unit (13) preferably being part of at least one of the grounding modules (8, 9).

## Revendications

1. Procédé de détection de points de frottement ou de contact sur des machines munies d'arbres en rotation, avec lequel les points de frottement ou de contact d'un arbre (1) sont déterminés lors du fonctionnement par le biais d'une mesure de l'état de mise à la terre de l'arbre (1) en mesurant tous les courants (i_{DE}, i_{RC}) qui circulent vers la terre (10) par le biais des liaisons de mise à la terre (6, 7, 8, 9) prévues de l'arbre (1), **caractérisé en ce qu'**un courant d'essai (17) est injecté au moins périodiquement sur l'arbre (1), que la détection des points de frottement ou de contact est réalisée par le biais d'une comparaison de l'intensité du courant d'essai (17) avec la différence (S₁ - S₀) entre le courant de terre total (S₁) qui s'écoule vers la terre (10) par le biais des liaisons de mise à la terre prévues (6, 7, 8, 9) de l'arbre (1) lorsque le courant d'essai (17) est appliqué et le courant de terre total (S₀) qui s'écoule vers la terre (10) par le biais des liaisons de mise à la terre prévues (6, 7, 8, 9) de l'arbre (1) lorsque le courant d'essai (17) n'est pas appliqué, et qu'un écart entre la différence des courants de terre et l'intensité du courant d'essai (17) injecté est interprété comme une indication de frottement de l'arbre et/ou de friction de l'arbre.

2. Procédé selon la revendication 1, **caractérisé en ce que** l'état de mise à la terre de l'arbre (1) est déterminé par le biais d'au moins un module de mise à la terre (8, 9) relié électriquement avec l'arbre (1) en mesurant la tension (U_{RC}, U_{DE}) par rapport à la terre (10) aux bornes d'une résistance de mise à la terre (11, 12).

3. Procédé selon la revendication 1 ou 2, **caractérisé en ce que** les courants (i_{RC}, i_{DE}) qui s'écoulent de l'arbre (1) vers la terre (10) sont interprétés comme étant positifs.

4. Procédé selon la revendication 1, 2 ou 3, **caractérisé en ce que** le courant d'essai (17) est injecté sur l'arbre (1) par le biais d'une liaison de mise à la terre (6, 7), notamment par le biais d'un balai de mise à la terre (6, 7) formant un contact avec l'arbre (1) ou d'un contact frotteur correspondant.

5. Procédé selon l'une des revendications 1 à 4, **caractérisé en ce que** le courant d'essai (17) est appliqué sur l'arbre au moins indirectement par le biais d'un module de mise à la terre (8, 9).

6. Procédé selon l'une des revendications 1 à 5, **caractérisé en ce que** la conductivité des points de frottement ou de contact est déterminée selon les principes de la distribution du courant sur des résistances à partir de la comparaison de l'intensité du courant d'essai (17) avec la différence entre le courant de terre total (S₁) avec application du courant d'essai (17) et le courant de terre total (S₀) sans application du courant d'essai (17).

7. Procédé selon l'une des revendications précédentes, **caractérisé en ce que** seule est analysée la composante de courant continu des courants de terre totaux (S₀, S₁) de l'arbre (1) qui circulent vers la terre (10) par le biais des liaisons de mise à la terre prévues (6, 7, 8, 9).

8. Procédé selon la revendication 7, **caractérisé en ce que** les courants de terre totaux (S₀, S₁) de l'arbre (1) qui circulent vers la terre (10) par le biais des liaisons de mise à la terre prévues (6, 7, 8, 9) sont moyennés dans le temps et/ou filtrés.

9. Procédé selon l'une des revendications précédentes, **caractérisé en ce que** les liaisons de mise à la terre prévues sont réalisées sous la forme d'au moins un module de mise à la terre (8, 9) qui est en contact avec l'arbre (1) et avec la terre (10) par le biais d'au moins un balai de mise à la terre (6, 7).

10. Dispositif pour mettre en oeuvre le procédé selon l'une des revendications précédentes, comprenant au moins un module de mise à la terre (8, 9) muni d'un balai de mise à la terre (6, 7) formant un contact avec l'arbre (1), l'au moins un module de mise à la terre (8, 9) disposant d'au moins une résistance de mise à la terre (11, 12), **caractérisé en ce qu'**il existe une unité (13) qui présente au moins indirectement par le biais d'un module de mise à la terre (8, 9) un contact pour l'injection d'un courant d'essai (17) défini sur l'arbre (1) et qui prélève la tension (U_{DE}, U_{RC}) présente aux bornes de l'au moins une résistance de mise à la terre (11, 12), et que l'unité (13) dispose de moyens pour mesurer et/ou interpréter les points de frottement ou de contact en se basant sur l'intensité du courant d'essai (17) et les courants de terre (i_{DE}, i_{RC}) qui circulent à travers les résistances de mise à la terre (11, 12), l'unité (13) étant réalisée de préférence sous la forme d'un élément constitutif d'au moins l'un des modules de mise à la terre (8, 9).
